# EUROPEAN PATENT SPECIFICATION

(11) **EP 1 774 649 B1**
(45) Date of publication and mention of the grant of the patent: **23.07.2008**
(21) Application number: 05744076.0
(22) Date of filing: 24.05.2005
(51) Int. Cl.: H03F 1/56, H03F 1/30

(54) **HIGH IMPEDANCE CIRCUIT**
HOCHIMPEDANZSCHALTUNG
CIRCUIT HAUTE IMPEDANCE

(30) Priority: 11.06.2004 GB 0413061
(43) Date of publication of application: 18.04.2007
(73) Proprietor: Toumaz Technology Limited, Abingdon Oxfordshire OX14 4RY (GB)
(72) Inventor: NIMMO, Ross, Swindon Wiltshire SN2 7QS (GB)
(74) Representative: Lind, Robert
(86) International application number: PCT/GB2005/050071
(87) International publication number: WO 2005/122392

(56) References cited:
- US-A- 4 471 319
- US-A- 5 315 169
- US-A- 5 686 860
- HOYLE C ET AL: "Bootstrapping techniques to improve the bandwidth of transimpedance amplifiers" ANALOG SIGNAL PROCESSING (REF. NO. 1998/472), IEE COLLOQUIUM ON, 28 October 1998 (1998-10-28), pages 7-1, XP006502909
- THOMPSON K: "A VERY HIGH INPUT IMPEDANCE BUFFER USING FIELD EFFECT TRANSISTORS" ELECTRONIC ENGINEERING, MORGAN-GRAMPIAN LTD. LONDON, GB, vol. 38, no. 460, June 1966 (1966-06), pages 370-373, XP001127066 ISSN: 0013-4902
- LANYI S ET AL: "A HIGH-INPUT-IMPEDANCE BUFFER" IEEE TRANSACTIONS ON CIRCUITS AND SYSTEMS I: FUNDAMENTAL THEORY AND APPLICATIONS, IEEE INC. NEW YORK, US, vol. 49, no. 8, August 2002 (2002-08), pages 1209-1211, XP001123006 ISSN: 1057-7122

## Description

### Field of the Invention

The present invention relates to circuits for simulating high impedances and in particular, though not necessarily, to high impedance simulating circuits suitable for incorporation into integrated circuits.

### Background to the Invention

There are many electrical circuits which require the use of very large impedances, for example in the giga Ohm (Gohm) range. Such large impedances are often required at the interface between an amplifier located on an integrated circuit and an off-chip transducer comprising, for example, piezoelectric material, ceramic, MEMS (micro-electronic machine systems), etc. An example of very large impedance is given by document US-A-4471319.

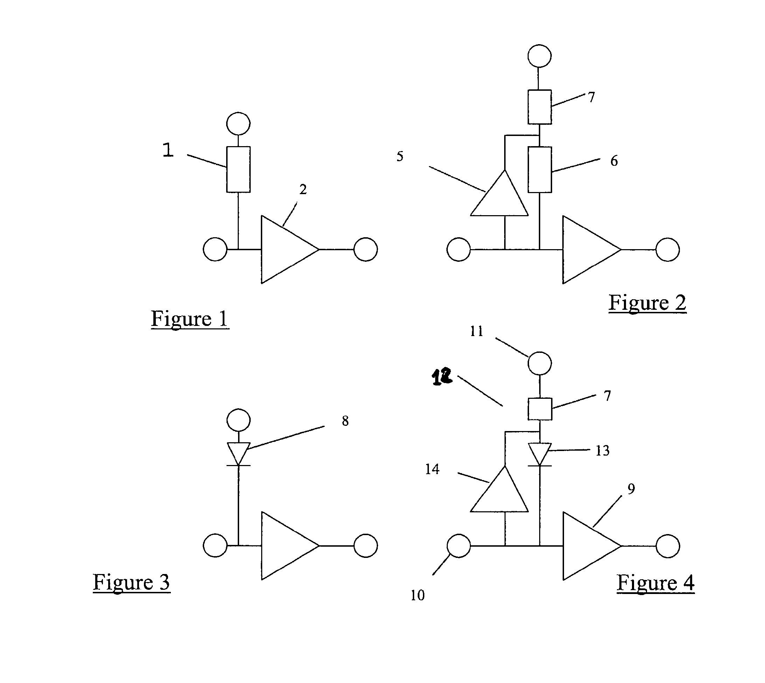

Figure 1 illustrates a resistor 1 connected between the input of an ac signal amplifier 2 having a signal input and a dc voltage line in order to provide voltage biasing for the amplifier. It is crucial for transducers of the type described above that the input impedance of the amplifier circuit be extremely high. The resistor 1 appears in parallel with the input impedance of the amplifier 2 as far as ac input signals are concerned, so in order to prevent the input impedance perceived by the input signal from dropping to an unacceptable level, the resistor 1 must have an extremely high value, preferably of the same order as the actual input impedance of the amplifier 2. Whilst large impedances are easy to manufacture in the form of discrete components for inclusion on printed circuit boards and the like, when it comes to fabricating integrated circuits, the provision of very large impedances on chip becomes a problem due to the large area which they occupy.

Circuit architectures for "simulating" high impedances and which are relatively inexpensive in terms of the chip space which they occupy have been developed and are in common use. One such circuit is illustrated in Figure 2 and might be termed a "bootstrapped impedance". This is suitable for ac applications. The circuit is implemented by applying a buffer amplifier 5 around a high value resistance 6. The resistance 7 provides a load for the buffer amplifier. The buffer amplifier 5 replicates the ac input signal voltage on both sides of the resistance. The voltage across the resistance (at the signal frequencies) will tend to zero, resulting in zero signal current through the resistance. The circuit therefore presents, in theory, an infinite impedance.

In practice, the impedance presented by the circuit illustrated in Figure 2 is significantly limited in size. This is due both to the presence of an offset voltage in the buffer amplifier (the output voltage is offset from the input voltage) and to the finite gain of the operational amplifier within the buffer amplifier. It is difficult to obtain a multiplication factor (of the resistance 6) of more than 1000. Assuming that the limit for economic integration of a resistance is around 2MOhms, the resistance which can be achieved with the circuit of Figure 2 is around 2GOhms. This impedance is not large enough for many transducer applications.

In order to provide an even higher impedance on-chip, use can be made of a diode, as illustrated in Figure 3. The resistance 1 of Figure 1 is replaced by a diode 8. Assuming a CMOS ac signal amplifier, only a very small current will be drawn through the diode when in use, typically only a few pA or less. The dc voltage drop across the diode is therefore of the order of a few mV, providing an effective impedance to the input ac signal of many GOhms.

Whilst the diode approach provides a readily integrateable solution, a significant disadvantage is that the impedance provided by the diode will be extremely temperature dependent, approximately halving with every 10 degree Celsius rise in temperature. Thus, for example, whilst at 25 degrees Celsius the diode may present an acceptable resistance of say several GOhms, at 85 degrees Celsius this will fall by a factor of 64. This is clearly unacceptable for many applications.

### Summary of the Invention

According to a first aspect of the present invention there is provided a signal amplifier circuit comprising:
a voltage signal amplifier having an input for receiving a signal to be amplified; and
an amplifier biasing arrangement coupled between the signal input and a dc voltage line, the arrangement comprising a diode means and a bootstrapping amplifier connected across the diode means which is configured to provide a very high impedance for said ac voltage to be amplified.

The amplifier circuit is suitable for amplifying ac signals, where the term "ac signal" refers to a varying signal. This may be a generally sinusoidal signal, or a complex signal such as the output from a microphone, medical monitoring system, or other transducer.

Embodiments of the invention make use of the bootstrapping amplifier to effectively multiply the impedance presented by the diode from the point of view of the ac input signal. Employing this technique allows an effective impedance of several tens or even hundreds of GOhms to be achieved.

The diode means may comprise a single diode. Alternatively, it may comprise a pair of diodes connected back to back as the offset voltage of the amplifier may be of either polarity.

Preferably, the signal amplifier circuit comprises a load resistance coupled between said amplifier biasing arrangement and said dc voltage line. The load resistance may be provided by a diode.

The or each diode of the circuit may comprise a transistor configured as a diode.

In a typical arrangement, said signal amplifier and said bootstrapping amplifier comprise CMOS components.

According to a second aspect of the present invention there is provided an integrated circuit comprising a signal amplifier circuit according to the above first aspect of the invention.

According to a third aspect of the present invention there is provided apparatus comprising an integrated circuit according to the above second aspect of the invention and a transducer, the input of the signal amplifier being coupled to an input node of the integrated circuit, the input node being further coupled to an output of the transducer.

### Brief Description of the Drawings

Figure 1 illustrates schematically a known ac signal amplifier having a high value resistance coupled to the amplifier input;
Figure 2 illustrates an alternative known circuit architecture in which the resistance of Figure 1 is replaced by a bootstrapped resistance;
Figure 3 illustrates a second alternative known circuit architecture in which the resistance of Figure 1 is replaced by a diode;
Figure 4 illustrates a circuit architecture embodying the present invention and in which the resistance of Figure 1 is replaced by a bootstrapped diode; and
Figure 5 illustrates in detail a preferred implementation of the circuit architecture of Figure 4.

### Detailed Description of Certain Embodiments of the Invention

Prior art circuit architectures for implementing a high impedance have been described above with reference to Figures 1 to 3. Figure 4 illustrates a new architecture which provides for a greatly increased impedance at the input of an ac signal amplifier. Furthermore, the impedance presented by the new architecture remains extremely high, even at elevated temperatures.

The circuit of Figure 4 is readily amenable to integration onto an integrated circuit which, for the purpose of this discussion, is assumed to make use of CMOS technology. The circuit comprises an ac signal amplifier 9 having an input 10 which is coupled to a pin of the integrated circuit. This pin might be coupled to a transducer such as a micro-electronic machine systems (MEMS), for example a MEMS operating as a microphone.

Coupled between the signal input 10 and a dc supply (bias) voltage rail 11 is a bootstrapping diode arrangement 12. This comprises a diode 13 which in use is arranged to be forward biased, with the supply rail being at a positive voltage with respect to the signal input 10. The arrangement 12 further comprises a bootstrapping buffer amplifier 14 having unity gain. The buffer amplifier 14 operates in a manner similar to that of the bootstrapping amplifier of the circuit of Figure 2, replicating the ac input signal voltage on both sides of the diode 13. For an ac input voltage of a few mV, the resulting ac current through the diode 13 will be extremely small indeed, perhaps only of the order of a fraction of a pA. At a "normal" temperature of around 25 degrees Celsius, the bootstrapping diode arrangement 12 may present an impedance to the input signal of a couple of hundred GOhms, falling to a few tens of GOhms at 85 degrees Celsius. This represents a significant improvement over the known architectures.

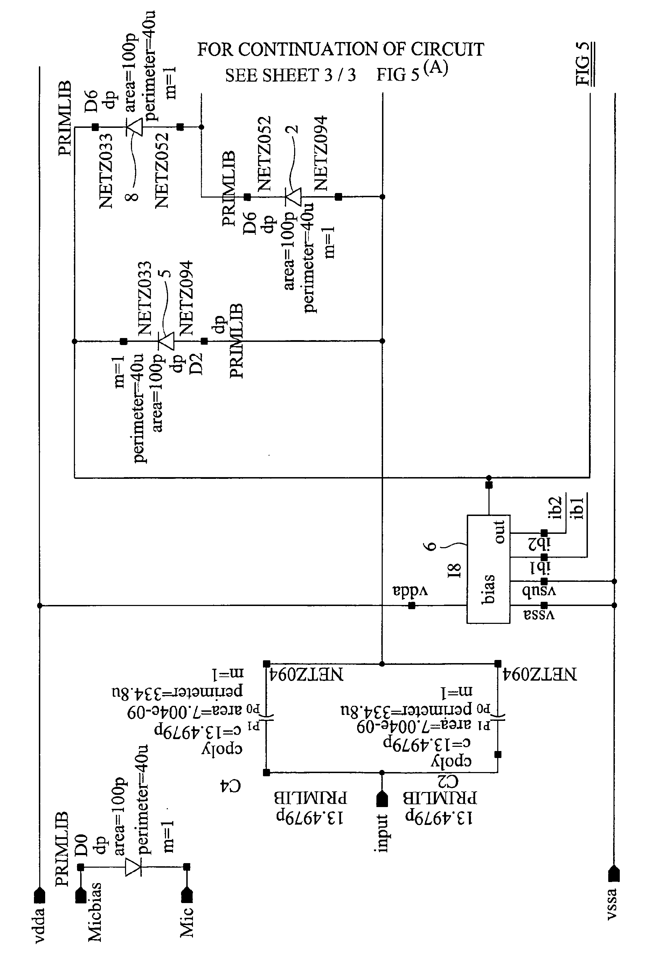

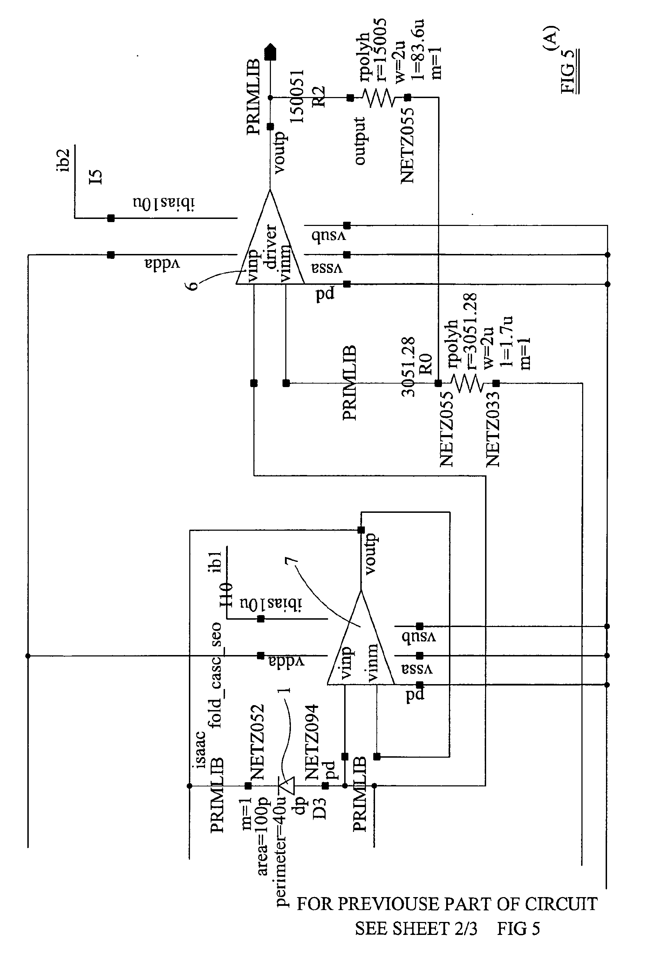

Figure 5 illustrates in detail one implementation of the circuit of Figure 4. The diode 13 of Figure 4 is replaced by a pair of back to back diodes 15,16 which provide improved performance as compared to a single diode. The load resistance for the buffer amplifier 14 is implemented using a further diode 17. The use of the diode 17 prevents feedback of the input signal into the bias circuit which would otherwise feed forward into the ac signal amplifier 9 causing the gain of the amplifier to vary in synchronisation with the ac input signal. A forth diode 18 is used to avoid transients on start up. The bootstrapping buffer amplifier 14 is implemented using a folded cascode single ended (s/e) output amplifier. A biasing circuit 19 provides the necessary dc voltage levels for biasing the amplifier circuit.

The diodes of the circuit of Figure 5 are implemented by means of transistors configured to operate as diodes. This simplifies the device fabrication process.

It will be appreciated by the person of skill in the art that various modifications may be made to the above described embodiment without departing from the scope of the present invention.

## Claims

1. A voltage signal amplifier circuit comprising:
a voltage signal amplifier (9) having a signal input (10) for receiving an ac voltage signal to be amplified; and
an amplifier biasing arrangement (12) coupled between the signal input (10) and a dc voltage line (11),
**characterised in that** said amplifier biasing arrangement (12) comprises a diode means (13) and a bootstrapping amplifier (14) connected across said diode means (13) which is configured to provide a very high impedance for said ac voltage to be amplified.

2. A circuit according to claim 1, the diode means comprising a single diode.

3. A circuit according to claim 1, the diode means comprising a pair of diodes connected back to back.

4. A circuit according to any one of the preceding claims and comprising a load resistance coupled between said amplifier biasing arrangement and said dc voltage line.

5. A circuit according to claim 4, the load resistance being provided by a diode.

6. A circuit according to any one of claims 2, 3, or 5, the or each diode comprising a transistor configured as a diode.

7. A circuit according to any one of the preceding claims, said signal amplifier and said bootstrapping amplifier comprising CMOS components.

8. An integrated circuit comprising a signal amplifier circuit according to any one of the preceding claims.

9. Apparatus comprising an integrated circuit according to claim 8 and a transducer, the input of the voltage signal amplifier being coupled to an input node of the integrated circuit, the input node being further coupled to an output of the transducer.

## Patentansprüche

1. Spannungssignalverstärkerschaltung, umfassend:
einen Spannungssignalverstärker (9) mit einem Signaleingang (10) zum Empfangen eines zu verstärkenden Wechselspannungssignals; und
eine Verstärkervorspannungsanordnung (12), verbunden zwischen dem Signaleingang (10) und einer Gleichspannungsleitung (11),
**dadurch gekennzeichnet, dass** die Verstärkervorspannungsanordnung (12) ein Diodenmittel (13) und einen Bootstrapping-Verstärker (14), der über das Diodenmittel (13) verbunden ist, umfasst, das konfiguriert ist, um eine sehr hohe Impedanz für die zu verstärkende Wechselspannung bereitzustellen.

2. Schaltung nach Anspruch 1, wobei das Diodenmittel eine einzelne Diode umfasst.

3. Schaltung nach Anspruch 1, wobei das Diodenmittel ein Paar von Dioden umfasst, die in Kreuzschaltung verbunden sind.

4. Schaltung nach einem der vorstehenden Ansprüche und umfassend einen Lastwiderstand, der zwischen der Verstärkervorspannungsanordnung und der Gleichspannungsleitung verbunden ist.

5. Schaltung nach Anspruch 4, wobei der Lastwiderstand durch eine Diode bereitgestellt wird.

6. Schaltung nach einem der Ansprüche 2, 3 oder 5, wobei die oder jede Diode einen Transistor umfasst, der als eine Diode konfiguriert ist.

7. Schaltung nach einem der vorstehenden Ansprüche, wobei der Signalverstärker und der Bootstrapping-Verstärker CMOS-Komponenten umfassen.

8. Integrierte Schaltung, umfassend eine Signalverstärkerschaltung nach einem der vorstehenden Ansprüche.

9. Vorrichtung, umfassend eine integrierte Schaltung nach Anspruch 8 und einen Wandler, wobei der Eingang des Spannungssignalverstärkers mit einem Eingangsknoten der integrierten Schaltung verbunden ist, wobei der Eingangsknoten weiter mit einem Ausgang des Wandlers verbunden ist.

## Revendications

1. Circuit d'amplificateur de signal de tension comprenant:
un amplificateur de signal de tension (9) comportant une entrée de signal (10) pour recevoir un signal de tension AC à amplifier; et
un agencement de polarisation d'amplificateur (12) couplé entre l'entrée de signal (10) et une ligne de tension DC (11),
**caractérisé en ce que** ledit agencement de polarisation d'amplificateur (12) comprend un moyen de diode (13) et un amplificateur d'amorçage (14) connecté aux bornes dudit moyen de diode (13), lequel est configuré pour fournir une impédance très élevée pour que ladite tension AC soit amplifiée.

2. Circuit selon la revendication 1, le moyen de diode étant constitué par une unique diode.

3. Circuit selon la revendication 1, le moyen de diode étant constitué par deux diodes connectées dos à dos.

4. Circuit selon l'une quelconque des revendications précédentes et comprenant une résistance de charge couplée entre ledit agencement de polarisation d'amplificateur et ladite ligne de tension DC.

5. Circuit selon la revendication 4, la résistance de charge étant constituée par une diode.

6. Circuit selon l'une quelconque des revendications 2, 3 ou 5, la ou chaque diode étant constituée par un transistor configuré en tant que diode.

7. Circuit selon l'une quelconque des revendications précédentes, ledit amplificateur de signal et ledit amplificateur d'amorçage étant constitués par des composants CMOS.

8. Circuit intégré comprenant un circuit d'amplificateur de signal selon l'une quelconque des revendications précédentes.

9. Appareil comprenant un circuit intégré selon la revendication 8 et un transducteur, l'entrée de l'amplificateur de signal de tension étant couplée à un noeud d'entrée du circuit intégré, le noeud d'entrée étant en outre couplé à une sortie du transducteur.
